(19) Europäisches Patentamt
European Patent Office
Office européen des brevets

(11) **EP 3 993 207 A1**

(12) **EUROPÄISCHE PATENTANMELDUNG**

(43) Veröffentlichungstag:
**04.05.2022 Patentblatt 2022/18**

(21) Anmeldenummer: **20204648.8**

(22) Anmeldetag: **29.10.2020**

(51) Internationale Patentklassifikation (IPC):
$H02J\ 3/00^{(2006.01)}$    $G06F\ 17/10^{(2006.01)}$
$G06N\ 3/02^{(2006.01)}$    $G06N\ 3/063^{(2006.01)}$
$G06N\ 3/10^{(2006.01)}$    $G06Q\ 50/06^{(2012.01)}$
$H02J\ 13/00^{(2006.01)}$

(52) Gemeinsame Patentklassifikation (CPC):
**H02J 3/00; G06N 3/02; G06N 3/063; G06N 3/10;
G06Q 50/06; H02J 13/00002;** H02J 2203/10

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft
80333 München (DE)**

(72) Erfinder:
• **Batz, Sascha
91334 Hemhofen (DE)**
• **Duckheim, Mathias
91052 Erlangen (DE)**

(54) **ZUSTANDSSCHÄTZUNG EINES STROMNETZES**

(57)     Es wird ein computergestütztes Verfahren zur Zustandsschätzung (2) eines Stromnetzes, insbesondere eines Nieder- und/oder Mittelspannungsnetzes, mittels eines künstlichen neuronalen Netzes (1) vorgeschlagen, wobei das neuronale Netz (1) einen oder mehrere mit dem Stromnetz technisch assoziierte Eingänge (41) aufweist, und die Zustandsschätzung (2) durch erfasste zeitliche Messsignale (4) des Stromnetzes, die als Eingänge (41) für das neuronale Netz (1) herangezogen werden, berechnet wird. Das Verfahren ist gekennzeichnet dadurch, dass wenigstens die Amplitude (42) einer Harmonischen eines der Messsignale (4) als Eingang (41) für das neuronale Netz (1) verwendet wird.

Weiterhin betrifft die Erfindung ein zugehöriges Verfahren zum Trainieren eines künstlichen neuronalen Netzes (1) sowie ein entsprechendes künstliches neuronales Netz (1).

FIG 1

EP 3 993 207 A1

**Beschreibung**

Die Erfindung betrifft ein Verfahren gemäß dem Oberbegriff des Patentanspruches 1, ein Verfahren gemäß dem Oberbegriff des Patentspruches 14 sowie ein künstliches neuronales Netz gemäß dem Oberbegriff des Patentanspruches 15.

Zur Regelung/Steuerung von Energieübertragungsnetzen, insbesondere von Stromnetzen, ist es wichtig, den Zustand des jeweiligen Netzes (Netzzustand) nahezu in Echtzeit zu erfassen. Die Bestimmung des Netzzustandes ist typischerweise nicht vollständig möglich, sodass hierzu eine Schätzung des Netzzustandes (Zustandsschätzung) verwendet wird. Aus dem Stand der Technik sind solche Schätzverfahren insbesondere für Hochspannungsnetze bekannt.

Für Niederspannungsnetze (Ortsnetze) ist der Netzzustand, das heißt beispielsweise die Spannung und/oder der Strom, die Wirk- und/oder Blindleistungseinspeisung/-ausspeisung an den Knotenpunkten beziehungsweise innerhalb von Zweigen des Stromnetzes typischerweise unbekannt. Besonders im Hinblick auf lokal erzeugte erneuerbare Energie und somit im Hinblick auf eine dezentrale Erzeugung von Energie, beispielsweise durch Photovoltaikanlagen, die ins örtliche Niederspannungsnetz einspeisen, sowie durch zusätzliche Belastungen, die bei der Planung des Stromnetzes nicht berücksichtigt wurden, wie beispielsweise Ladevorgänge von Elektrofahrzeugen und Wärmepumpen, wird die Erfassung des Netzzustandes, das heißt die Zustandsschätzung für Stromnetze, immer wichtiger. Das ist insbesondere deshalb der Fall, da der Netzbetreiber für die Netzzustandsgrößen des Netzes, beispielsweise Spannungen, Ströme und/oder Leistungen, die Einhaltung von jeweiligen Grenzwerten sicherstellen muss.

Insbesondere im Hinblick auf neuerer Entwicklungen, wie beispielsweise lokale Energiemärkte, die im Wesentlichen durch eine dezentrale und lokale Regelung des Verbrauchs und der Erzeugung gekennzeichnet sind, ist die Kenntnis des Netzzustandes von Bedeutung.

Eine solcher lokaler Energiemarkt für den Austausch elektrischer Energie ist beispielsweise aus dem Dokument EP 3518369 A1 bekannt.

Typischerweise werden die Netzzustandsgrößen - wenn überhaupt - bei Niederspannungsnetzen an einzelnen zentralen Messstellen, wie beispielsweise Trafostationen, erfasst. Hierbei sind jedoch die Netztopologie sowie der Netzzustand des tieferliegenden Netzes größtenteils unbekannt.

Grundsätzlich könnte der Netzzustand durch Messung der entsprechenden Netzzustandsgrößen (Messgrößen), wie Spannung, Strom, Wirkleistung und/oder Blindleistung, an allen vorhandenen Knotenpunkten des Stromnetzes ermittelt werden. Dies wäre jedoch mit einem hohen Aufwand und hohen Investitionen für Messgeräte, Inbetriebnahme und Konfiguration sowie Betrieb verbunden, die für die typischen Kostenstrukturen für Mittel- und/oder Niederspannungsnetze zu groß sind.

Vorteilhafter sind Verfahren, die basierend auf wenigen Messsignalen den Netzzustand schätzen können (Zustandsschätzung; engl. State Estimation). Der Begriff der Zustandsschätzung bezeichnet somit das Abschätzen des aktuellen Netzzustandes auf Basis von Messungen, das heißt Messsignalen.

Grundsätzlich wird versucht basierend auf einem erfassten Summensignal einer Messstelle auf den Verbrauch und/oder die Erzeugung der hinter der Messstelle liegenden Anlagen zu schließen (Disaggregation). Bezeichnet $P_i(t)$ beispielsweise die Leistungseinspeisungen verschiedener Anlagen $i = 1,...,N$, so wird ein Summensignal

$$P(t) = \sum_{i=1}^{N} P_i(t),$$ etwa an einer Trafostation, gemessen. Somit ist eine Disaggregation eine Zuordnung $P(t) \rightarrow (P_1(t), P_2(t), ..., P_N(t))$. Eine solche Disaggregation ist jedoch äußerst komplex und stark unterbestimmt, sodass typischerweise lediglich eine Schätzung bezüglich des Netzzustandes erfolgen kann (Zustandsschätzung).

Für die Zustandsschätzung von Stromnetzen können künstliche neuronale Netze (engl. Artificial Neural Network; abgekürzt ANN), das heißt KIs, verwendet werden.

Der vorliegenden Erfindung liegt die Aufgabe zugrunde, ein verbessertes Verfahren zur Zustandsschätzung eines Stromnetzes mittels eines künstlichen neuronalen Netzes bereitzustellen. Weiterhin ist es die Aufgabe der vorliegenden Erfindung ein verbessertes Training sowie ein verbessertes künstliches neuronales Netz zur Zustandsschätzung bereitzustellen.

Die Aufgabe wird durch ein Verfahren mit den Merkmalen des unabhängigen Patentanspruches 1, durch ein Verfahren mit den Merkmalen des unabhängigen Patentspruches 14 sowie durch ein künstliches neuronales Netz mit den Merkmalen des unabhängigen Patentspruches 15 gelöst. In den abhängigen Patentansprüchen sind vorteilhafte Ausgestaltungen und Weiterbildungen der Erfindung angegeben.

Das erfindungsgemäße computergestützte Verfahren zur Zustandsschätzung eines Stromnetzes, insbesondere eines Nieder- und/oder Mittelspannungsnetzes, mittels eines künstlichen neuronalen Netzes, wobei das neuronale Netz einen oder mehrere mit dem Stromnetz technisch assoziierte Eingänge aufweist, und die Zustandsschätzung durch erfasste zeitliche Messignale des Stromnetzes, die als Eingänge für das neuronale Netz herangezogen werden, berechnet wird, ist gekennzeichnet dadurch, dass wenigstens die Amplitude einer Harmonischen eines der Messsignale als Eingang für das neuronale Netz verwendet wird.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt sein.

Mittels einer Zustandsschätzung (Netzzustandsschätzung) eines Stromnetzes werden grundsätzlich Zustandsgrößen des Stromnetzes, insbesondere seine komplexen Spannungswerte sowie Stromwerte, an mehreren Knotenpunkten und/oder Zweigen des Stromnetzes berechnet und abgeschätzt. Dies erfolgt basierend auf Messwerten beziehungsweise Messsignalen der genannten Zustandsgrößen, die lediglich in einzelnen Bereichen oder an einzelnen Punkten des Stromnetzes erfasst wurden oder erfasst werden.

Vorliegend wird ein künstliches neuronales Netz als neuronales Netz bezeichnet, sodass unter dem Begriff des neuronalen Netzes stets künstliche neuronale Netze (ANN) verstanden werden.

Das neuronale Netz weist wenigstens eine Eingabeschicht (engl. Input Layer), eine oder mehrere verborgene Schichten (engl. Hidden Layers) sowie eine Ausgabeschicht (engl. Output Layer) auf. Die Eingabeschicht des neuronalen Netzes und somit das neuronale Netz umfasst mehrere technisch mit dem Stromnetz assoziierte Eingänge. Mit anderen Worten können Werte technischer Größen des Stromnetzes, beispielsweise seine Spannungen an mehreren Knotenpunkten, einem der Eingänge des neuronalen Netzes als Eingabewert zugeführt werden. Mit anderen Worten werden an den Eingängen des neuronalen Netzes Eingangswerte beziehungsweise Eingabewerte angelegt. Die Eingänge beziehungsweise die Eingabewerte werden vorliegend wenigstens teilweise basierend auf zeitlichen Messsignalen des Stromnetzes ermittelt. In Abhängigkeit der genannten Eingänge beziehungsweise der zugehörigen Eingabewerte berechnet das neuronale Netz einen oder mehrere Ausgabewerte. Mit anderen Worten weist das neuronale Netz einen oder mehrere Ausgänge auf. Die Ausgabewerte entsprechen somit einer bestimmten Zustandsschätzung.

Die Eingänge können somit ebenfalls als Eingangsneuronen und die Ausgänge als Ausgangsneuronen des neuronalen Netzes aufgefasst werden. Wird somit eine Größe, wie beispielsweise die Amplitude einer Harmonischen, als Eingang des neuronalen Netzes verwendet, so bedeutet dies in anderen Worten, dass wenigstens einem Eingabeneuron des neuronalen Netzes der Wert der Größe als Eingabewert zugeführt wird.

Die Amplitude der Harmonischen ist grundsätzlich komplexwertig, das heißt diese weist einen Betrag und eine Phase beziehungsweise einen Realteil sowie einen Imaginärteil auf. Vorliegend umfasst der Begriff der Amplitude somit den Betrag der Amplitude, die Phase, den Realteil und den Imaginärteil der Harmonischen. Mit anderen Worten kann die komplexwertige Amplitude, der Betrag der Amplitude, der Realteil und/oder der Imaginärteil der Amplitude der Harmonischen einzeln oder in Kombination als Eingang beziehungsweise Eingänge verwendet werden.

Gemäß der vorliegenden Erfindung wird wenigstens die Amplitude einer der Harmonischen eines der Messsignale als Eingang für das neuronale Netz verwendet. Mit anderen Worten weist das neuronale Netz einen Eingang beziehungsweise ein Eingangsneuron auf, welchem die Amplitude beziehungsweise der Amplitudenwert der Harmonischen des Messsignals als Eingabe beziehungsweise Eingabewert zugeführt werden kann. Das neuronale Netz ist derart ausgebildet und trainiert, dass es die Amplitude der Harmonischen zum Berechnen der Zustandsschätzung des Stromnetzes berücksichtigt und verwendet. Mit anderen Worten werden, gegebenenfalls ergänzend zu den direkt erfassten Messsignalen, erfindungsgemäß spektrale Daten der Messsignale (Frequenzraum) für die Zustandsschätzung verwendet.

Weist beispielsweise das als Wechselspannungsnetz ausgebildete Stromnetz die Grundfrequenz $f_0$ auf, beispielsweise 50 Hz oder 60 Hz, so ist eine Harmonische des Messsignals dadurch gekennzeichnet, dass diese eine Frequenz aufweist, die ein ganzzahliges Vielfaches der genannten Grundfrequenz des Stromnetzes ist. Bezeichnet beispielsweise $U(t)$ das zeitliche Messsignal der Spannung an einem Knotenpunkt des Stromnetzes für einen bestimmten Zeitbereich, so ist $\hat{A}_m = |\hat{U}(f = mf_0)|$ die Amplitude der $m$-ten Harmonischen des Zeitsignals, wobei $\hat{U}(f)$ die Fourier-Transformierte (Spektralfunktion) des Messsignals bezeichnet. Grundsätzlich kann die komplexe Amplitude $\hat{A}_m = \hat{U}(f = mf_0)$ und/oder deren Realteil $\hat{A}_m = \mathrm{Re}[\hat{U}(f = mf_0)]$ oder/oder der Imaginärteil $\hat{A}_m = \mathrm{Im}[\hat{U}(f = mf_0)]$ und/oder deren Betrag $\hat{A}_m = |\hat{U}(f = mf_0)|$ und/oder deren Phase als Amplitude im Sinne der vorliegenden Erfindung verwendet werden.

Mit anderen Worten ist es ein Grundgedanke der vorliegenden Erfindung, nicht nur die einzelnen zeitlichen Messsignale $U(t)$ beispielsweise zum Training des neuronalen Netzes und/oder zur Zustandsschätzung heranzuziehen, sondern erfindungsgemäß zusätzlich Werte der frequenzabhängigen zugehörigen Spektralfunktion des Messsignals $\hat{U}(f)$ zu verwenden.

Die Amplituden der Harmonischen des Messsignals sind zur Zustandsschätzung besonders gut geeignet, da diese charakteristisch für nichtlineare Komponenten und/oder Anlagen des Stromnetzes sind. Die Harmonischen bilden somit sinnbildlich eine Art Fingerabdruck für die an das Stromnetz angeschlossenen Komponenten und/oder Anlagen aus. Somit wird durch das erfindungsgemäße entsprechend ausgebildete und trainierte neuronale Netz die Zustandsschätzung für das Stromnetz verbessert.

Ein weiterer Vorteil der vorliegenden Erfindung ist, dass eine verbesserte Schätzung des Netzzustandes (Zustandsschätzung) ohne weitere oder größere Installationen beziehungsweise Investitionen in das Stromnetz erreicht werden kann. Das ist deshalb der Fall, da im Wesentlichen das kumulierte erfasste Messsignal am jeweiligen Knotenpunkt des Stromnetzes, insbesondere lediglich am nullten Knotenpunkt des Stromnetzes, beispielsweise an einer Trafostation, ausreichend ist.

Weiterhin ist das erfindungsgemäße Verfahren ressourcenschonend, da eine Fourier-Transformation, beispielsweise mittels schneller Fourier-Transformation (engl. Fast Fourier Transform; abgekürzt FFT), effizient implementierbar ist, oder bereits direkt durch die Messeinrichtung, die das Messsignal erfasst und für das neuronale Netz bereitstellt, ausführbar ist.

Die vorliegende Erfindung stellt somit eine verbesserte Netzzustandsschätzung, insbesondere für stark unterdeterminierte Systeme, wie beispielsweise Mittelspannungs- oder Niederspannungsnetze, bereit. Dadurch kann eine verbesserte intelligente Regelung des Stromnetzes, insbesondere im Hinblick auf digitale Stromnetze, erreicht werden.

Gemäß einer vorteilhaften Ausgestaltung der Erfindung wird die Amplitude der Harmonischen mittels einer Fourier-Transformation des Messsignals ermittelt.

Mittels der Fourier-Transformation wird vorteilhafterweise das Spektrum des Messsignals ermittelt. Das Spektrum beziehungsweise die aus dem Messsignal ermittelte Spektralfunktion weist für ein Stromnetz typischerweise mehrere Spitzenwerte (engl. Peaks) auf, die den Harmonischen beziehungsweise ihren Amplituden entsprechen. Vorteilhafterweise können mittels der Fourier-Transformation somit die Harmonischen und ihre zugehörigen Amplituden schnell und effizient ermittelt werden. Weiterhin können zusätzliche zeitliche und/oder spektrale Filter vorgesehen sein. Beispielsweise wird lediglich ein bestimmter Zeitbereich für die Fourier-Transformation verwendet und/oder ein bestimmter Frequenzbereich zum Ermitteln der Amplituden der Harmonischen berücksichtigt. Zum Ermitteln oder Bestimmen der Amplituden kann grundsätzlich jedes bekannte Verfahren, insbesondere eine FFT, verwendet werden.

In einer vorteilhaften Weiterbildung der Erfindung werden zusätzlich ein oder mehrere Verhältnisse von Amplituden von Harmonischen des Messsignals als Eingänge verwendet.

Mit anderen Worten ist das neuronale Netz derart ausgebildet und trainiert, dass das Verhältnis der Amplituden diesem als Eingabewert für ein Eingabeneuron zugeführt werden kann. Dadurch wird vorteilhafterweise die Zustandsschätzung für das Stromnetz verbessert. Das ist deshalb Fall, da Komponenten und/oder Anlagen des Stromnetzes ein bestimmtes Verhältnis von Amplituden von Harmonischen aufweisen. Mit anderen Worten ist das Verhältnis von Amplituden bestimmter Harmonischer ein verbesserter Fingerabdruck für die jeweiligen Komponenten und/oder Anlagen des Stromnetzes. So gilt beispielsweise für Netzteile $|\hat{U}_5/\hat{U}_0| \in [0.5, 0.7]$, wobei $\hat{U}_5$ die Amplitude der 5-ten Harmonischen und $\hat{U}_0$ die Amplitude der Grundfrequenz bezeichnet.

Gemäß einer vorteilhaften Ausgestaltung der Erfindung werden zusätzlich eine oder mehrere Anstiegszeiten und/oder ein oder mehrere Abfallzeiten innerhalb des Messsignals als Eingänge verwendet.

Mit anderen Worten werden aus dem Messsignal ermittelte Anstiegszeiten und/oder Abfallzeiten als Eingabewerte für das neuronale Netz verwendet. Hierbei ist das neuronale Netz wiederum entsprechend ausgebildet und trainiert, sodass dieses die Anstiegszeiten und/oder Abfallzeiten als Eingabe berücksichtigen kann. Mit anderen Worten weist das neuronale Netz Eingänge beziehungsweise Eingangsneuronen für die aus dem Messsignal beziehungsweise Messsignalen ermittelten Anstiegszeiten und/oder Abfallzeiten auf.

Die Anstiegszeiten und/oder Abfallzeiten werden aus dem Messsignal ermittelt. Liegen mehrere Messsignale bereit, so können für jedes Messsignal Anstiegszeiten und/oder Abfallzeiten ermittelt und durch das neuronale Netz berücksichtigt werden. Die Anstiegszeiten und/oder Abfallzeiten sind charakteristisch für die an das Stromnetz angeschlossenen Komponenten/Anlagen. Beispielsweise weist eine Wärmepumpe eine charakteristische Anstiegszeit auf. Somit bilden die Anstiegszeiten und/oder Abfallzeiten einen zusätzlichen Fingerabdruck für die Komponenten und/oder Anlagen des Stromnetzes aus. Das neuronale Netz berücksichtigt diese beziehungsweise kann durch diese verbessert trainiert werden, sodass dadurch eine verbesserte Zustandsschätzung ermittelt werden kann.

In einer vorteilhaften Ausgestaltung der Erfindung werden die Anstiegszeiten und/oder Abfallzeiten mittels eines Pade-Laplace-Verfahrens ermittelt, wobei die Anstiegszeiten und/oder Abfallzeiten durch die Pole der Pade-Approximation der Laplace-Transformierten des Messsignals ermittelt werden.

Wie bereits obenstehend genannt, bilden die Anstiegszeiten und/oder Abfallzeiten einen vorteilhaften Fingerabdruck für Komponenten und/oder Anlagen des Stromnetzes aus. Das Ermitteln der Anstiegszeiten und/oder Abfallzeiten ist jedoch nicht ohne Weiteres aus dem Messsignal oder seiner Fourier-Transformierten möglich.

Vorliegend werden die Anstiegszeiten und/oder Abfallzeiten bevorzugt mittels des Pade-Laplace-Verfahrens (engl. Pade-Laplace-Fitting) ermittelt. Hierzu wird die Laplace-Transformierte des Messsignals, beispielsweise numerisch, ermittelt. Die Laplace-Transformierte eines oder mehrerer exponentieller Anstiege/Abfälle weist reellwertige Polstellen auf, die den charakteristischen Anstiegszeiten und/oder Abfallzeiten entsprechen. Das Residuum der Polstellen entspricht der Amplitude des Anstiegs/Abfalls. Somit können die Anstiegszeiten und/oder Abfallzeiten grundsätzlich aus der Laplace-Transformierten ermittelt werden. Beispielsweise hat ein charakteristischer Abfall innerhalb des Messsignals der Form $f(t) \sim a \cdot \exp(-kt)$ die Laplace-Transformierte $L(s) \sim a/(k + s)$. Somit weist diese eine Polstelle für $s^* = -k$ auf. Die charakteristische Abfallzeit $T$ wird in diesem einfachen Beispiel durch $T = 1/k = 1/|s^*|$ ermittelt.

Allerdings können mehrere Anstiege/Abfälle gleichzeitig innerhalb des Messsignals vorhanden sein, sodass die Laplace-Transformierte mehrere zugehörige Polstellen aufweist. Zum Ermitteln mehrerer Polstellen und somit mehrerer Abfallzeiten und/oder Anstiegszeiten wird die Laplace-Transformierte vorteilhafterweise durch einen Pade-Approximation approximiert. Hierbei wird eine rationale Funktion (engl. Pade-Approximant) der Ordnung [n/m] ermittelt, welche die Laplace-Transformierte approximiert. Das ist deshalb von Vorteil, da die Polstellen der Laplace-Transformierten durch die Nullstellen des Nenners der ermittelten rationalen Funktion besonders effizient ermittelt werden können. Dadurch können die technisch charakteristischen Anstiegszeiten und/oder Abfallzeiten von Komponenten und/oder Anlagen des Stromnetzes, selbst bei einer Überlagerung ihrer Anstiege/Abfälle im Messsignal, besonders vorteilhaft ermittelt werden.

Besonders bevorzugt wird für die Pade-Approximation die Ordnung [$n/(n - 1)$] verwendet ($n \geq 2$). Mit anderen Worten ist besonders bevorzugt der Zähler des Pade-Approximanten ein Polynom $n$-ten Grades und der Nenner des Pade-Approximanten ein Polynom ($n - 1$)-ten Grades. Das ist deshalb von Vorteil, da dadurch sichergestellt wird, dass die Polstellen des Pade-Approximanten $R_{n-1}^n(s)$ den charakteristischen Anstiegszeiten und/oder Abfallzeiten innerhalb des Messsignals entsprechen.

Ist beispielsweise $L(s) = \int_0^\infty f(t)e^{-st}\mathrm{d}t$ die Laplace-Transformierte des zeitlichen Messsignals $f(t)$, so wird die im Sinne des Pade-Laplace-Verfahrens bestmögliche rationale Funktion mit

$$L(s) \approx R_{n-1}^n(s) = \sum_{j=0}^n a_j s^j / (1 + \sum_{j=1}^{n-1} b_j s^j)$$

ermittelt, wobei hierzu die Koeffizienten $a_j$ und $b_j$ bestimmt werden. Die Anstiegszeiten und/oder Abstiegszeiten werden daher durch $1 + \sum_{j=1}^{n-1} b_j s^j = 0$ bestimmt, wobei mathematisch äquivalente Formulierungen des Nenners $R_{n-1}^n(s)$ hierzu äquivalent sind. Die ermittelten Nullstellen des Nenners des Pade-Approximanten beziehungsweise die ermittelten Polstellen $s^*$ entsprechen schließlich, beispielsweise über $T = 1/|s^*|$, den charakteristischen Anstiegszeiten und/oder Abfallzeiten. Äquivalent zu derart bestimmten Anstiegszeiten und/oder Abfallzeiten können die zugehörigen Werte der Polstellen ($s^*$) direkt als Eingänge für das neuronale Netz zur Zustandsschätzung und/oder zum Trainieren des neuronalen Netzes verwendet werden.

Gemäß einer vorteilhaften Ausgestaltung der Erfindung wird $n$ bis zu einem festgelegten maximalen Wert solange erhöht, bis keine weiteren Anstiegszeiten und/oder Abfallzeiten ermittelt werden.

Vorteilhafterweise können dadurch alle in dem Messsignal vorhandenen charakteristischen Abfallzeiten und/oder Anstiegszeiten ermittelt werden. Das ist deshalb der Fall, da mit jeder Erhöhung von $n$ grundsätzlich eine weitere Nullstelle des Nenners (Polstelle) des Pade-Approximanten hinzukommen kann. Wird $n$ erhöht und kommt keine weitere Polstelle mehr hinzu, so kann davon ausgegangen werden, dass alle vorhandenen charakteristischen Anstiegszeiten und/oder Abfallzeiten ermittelt wurden.

Somit umfasst ein besonders bevorzugtes Verfahren zum Ermitteln der Anstiegszeiten und/oder Abfallzeiten für eine Zustandsschätzung eines Stromnetzes die folgenden Schritte:

- Berechnen der Laplace-Transformierten des Messsignals;
- Ermitteln des Pade-Approximanten der Ordnung [$n/(n - 1)$] für die berechnete Laplace-Transformierte;
- Ermitteln der Polstellen des Pade-Approximanten, wobei die Anstiegszeiten und/oder Abfallzeiten durch die Polstellen bestimmt sind; und
- Erhöhen von $n$ ($n{\to}n + 1$) bis keine weiteren Polstellen mehr auftreten.

Die derart aus dem Messsignal beziehungsweise den Messsignalen ermittelten Anstiegszeiten und/oder Abfallzeiten werden anschließend den Eingängen des neuronalen Netzes zur Zustandsschätzung zugeführt und/oder zum Trainieren des neuronalen Netzes verwendet.

In einer vorteilhaften Weiterbildung der Erfindung werden zusätzlich Amplituden von Subharmonischen des Messsignals als Eingänge verwendet.

Mit anderen Worten ist das neuronale Netz derart ausgebildet und trainiert, dass dieses Subharmonische des Messsignals als Eingänge zur Zustandsschätzung berücksichtigt beziehungsweise verwendet. Subharmonische treten beispielsweise auf, wenn das Messsignal charakteristische nicht periodische Anteile umfasst.

Gemäß einer vorteilhaften Ausgestaltung der Erfindung werden die Messsignale an Knotenpunkten des Stromnetzes, insbesondere an Umspannwerken und/oder Transformatorenstationen, erfasst.

Dadurch wird vorteilhafterweise die Zustandsschätzung für das Stromnetz verbessert. Weiterhin sind die Knotenpunkte besonders vorteilhaft, da typischerweise diese durch für das Stromnetz charakteristische und zugängliche Anlagen, wie beispielsweise Umspannwerke, Transformatorstationen und/oder Stromkästen, gebildet werden. Dort ist das Erfassen der Messsignale, beispielsweise das Messen der Spannung, des Stromes, der Wirkleistung und/oder Blindleistung, einfach möglich. Zudem können zusätzliche Messgeräte, falls erforderlich und vorteilhaft, dort einfach installiert beziehungsweise nachgerüstet werden. Weiterhin berücksichtigt das Erfassen der Messsignale an den Knotenpunkten des Stromnetzes die Netztopologie des Stromnetzes.

In einer vorteilhaften Weiterbildung der Erfindung wird als neuronales Netz ein neuronales Netz verwendet, welches mittels eines Trainingsdatensatzes trainiert wurde, der mehrere Amplituden von Harmonischen eines und/oder mehrerer Messsignale umfasst, wobei zum Trainieren des neuronalen Netzes die Amplituden der Harmonischen als Eingänge verwendet wurden beziehungsweise werden.

Weiterhin ist es bevorzugt, wenn als neuronales Netz ein neuronales Netz verwendet wird, welches mittels eines Trainingsdatensatzes trainiert wurde, der mehrere Anstiegszeiten und/oder Abfallzeiten von einem und/oder mehreren Messsignalen umfasst, wobei zum Trainieren des neuronalen Netzes die Anstiegszeiten und/oder Abfallzeiten als Eingänge verwendet wurden beziehungsweise werden.

Mit anderen Worten ist das derart trainierte neuronale Netz dazu ausgebildet, für ein oder mehrere unbekannte Messsignale, welche nicht zum Trainieren verwendet wurden und beispielswiese aktuell an einem oder mehreren Knotenpunkten des Stromnetzes erfasst wurden, die Amplituden von Harmonischen des Messsignals und/oder aus dem Messsignal ermittelte Anstiegszeiten und/oder Abfallzeiten als Eingänge zu berücksichtigen und somit zur Zustandsschätzung für das Stromnetz zu verwenden.

Gemäß einer vorteilhaften Ausgestaltung der Erfindung erfolgt die Zustandsschätzung für ein als Niederspannungsnetz und/oder Mittelspannungsnetz ausgebildetes Stromnetz.

Mit anderen Worten ist das Stromnetz bevorzugt als Niederspannungsnetz und/oder Mittelspannungsnetz ausgebildet. Das ist deshalb von Vorteil, da insbesondere für Niederspannungsnetze und/oder Mittelspannungsnetze keine ausreichende messwertbasierte Kenntnis über den Netzzustand vorhanden ist. Die vorliegende Erfindung löst dieses technische Problem durch ein entsprechend ausgestaltetes neuronales Netz, welches erfindungsgemäß spektrale Daten sowie ergänzend charakteristische Anstiegszeiten und/oder Abfallzeiten für die Zustandsschätzung berücksichtigt beziehungsweise direkt mit einbezieht.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:

Figur 1    ein Ablaufdiagramm für eine Zustandsschätzung gemäß einer Ausgestaltung der vorliegenden Erfindung; und
Figur 2    ein Diagramm zur Veranschaulichung der spektralen Daten (Harmonische) eines Messsignals.

Gleichartige, gleichwertige oder gleichwirkende Elemente können in einer der Figuren oder in den Figuren mit denselben Bezugszeichen versehen sein.

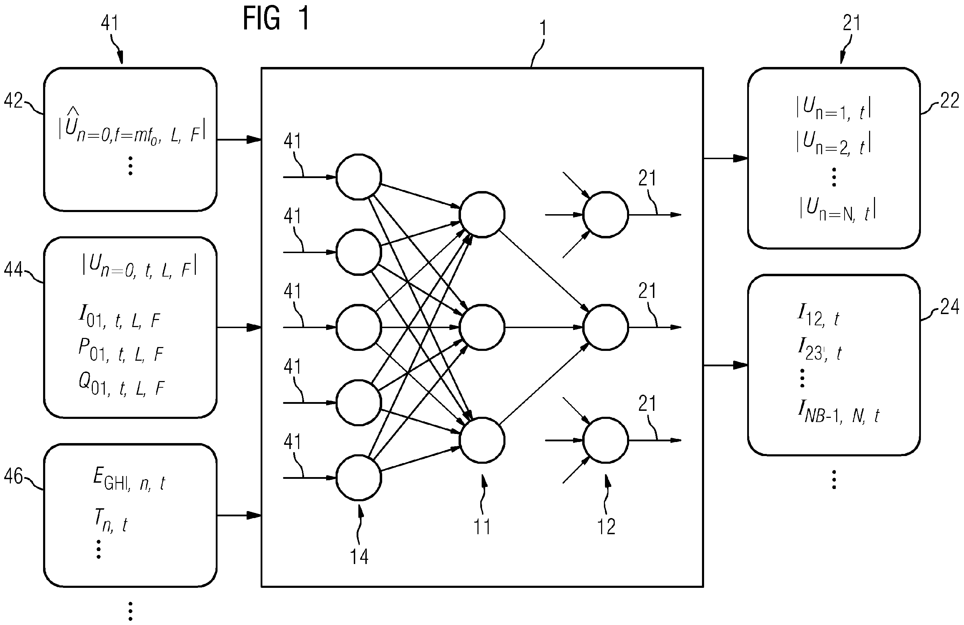

Die Figur 1 zeigt einen schematischen Ablauf einer Zustandsschätzung 21 für ein Stromnetz unter der Verwendung eines gemäß der vorliegenden Erfindung ausgestalteten und trainierten neuronalen Netzes 1.

In der Figur 1 ist das neuronale Netz 1 durch seine Neuronen (Kreise) sowie ihre Verbindungen (Pfeile) symbolisch dargestellt.

Das neuronale Netz 1 weist eine Eingabeschicht 14 mit mehreren Eingängen 41, eine oder mehrere verborgene Schichten 11 sowie eine Ausgabeschicht 12 mit mehreren Ausgängen 21 auf.

Werden der Eingabeschicht 14 beziehungsweise jedem der Eingänge 41 entsprechende Daten zugeführt beziehungsweise an der Eingabeschicht 14 angelegt, so berechnet das neuronale Netz 1 über seine verborgenen Schichten 11 die Ausgaben 21, die den Ausgängen 21 des neuronalen Netzes entsprechen. Die Ausgaben beziehungsweise Ausgänge 21 entsprechen für die zugeführten Eingänge 41 dann der Zustandsschätzung für das Stromnetz, sodass die Zustandsschätzung mit demselben Bezugszeichen 21 gekennzeichnet ist.

Zum Berechnen der Zustandsschätzung 21 sind somit Eingangswerte beziehungsweise Eingangsdaten erforderlich, die den Eingängen 41 des neuronalen Netzes 1 zugeführt werden müssen. Mit anderen Worten können die Eingänge 41 mit diesen Daten/Werten identifiziert werden, da jedem bestimmten Wert, beispielsweise einem Spannungswert, ein festgelegter Eingang 41 zugeordnet ist.

Vorliegend werden mehrere verschiedene Daten/Werte/Eingänge, die in der Figur in Kästen 42, 44, 46 kategorisiert sind, verwendet.

Gemäß der vorliegenden Ausgestaltung werden die Amplituden von Harmonischen 42 der Messsignale, Anstiegszeiten 42 innerhalb der Messsignale und/oder Abfallzeiten 42 innerhalb der Messsignale als Eingänge 41 verwendet. In der Figur 1 werden diese erfindungsgemäßen Eingänge, das heißt die Amplituden von Harmonischen, die Anstiegszeiten und/oder die Abfallzeiten durch den Kasten 42 zusammenfasst, sodass diese vorliegend dasselbe Bezugszeichen 42 aufweisen. Weiterhin können Verhältnisse von Amplituden von Harmonischen innerhalb desselben Messsignals und/oder über verschiedene Messsignale hinweg als Eingänge 41 verwendet werden.

Die Messsignale werden für die Zustandsschätzung 21 am Stromnetz, insbesondere an Knotenpunkten des Stromnetzes, erfasst. Beispielsweise erfolgt die Erfassung innerhalb eines Zeitbereiches, wobei dann die Zustandsschätzung 21 für den genannten Zeitbereich berechnet wird. Mit anderen Worten kann eine zeitaufgelöste Zustandsschätzung basierend auf aktuell erfassten Messsignalen erfolgen. Die Messsignale können Spannungssignale, Stromsignale, Wirkleistungssignale und/oder Blindleistungssignale sein. Mit anderen Worten können die Messsignale die Spannung, den Strom, die Wirkleistung und/oder die Blindleistung (Messgrößen) an jeweiligen Knotenpunkten und/oder Zweigen des Stromnetzes innerhalb eines festgelegten oder bestimmten Zeitbereiches erfassen. Mit anderen Worten wird ein zeitlicher Verlauf der jeweiligen Messgröße an einem oder mehreren Knotenpunkten des Stromnetzes erfasst. Sind die genannten Zeitbereiche ausreichend kurz und erfolgt für jeden Zeitbereiche eine solche messwertbasierte beziehungsweise messsignalbasierte Zustandsschätzung 21 mittels des neuronalen Netzes 1, so wird eine Zustandsschätzung 21 in Echtzeit erreicht.

Das Ermitteln der Amplituden der Harmonischen erfolgt typischerweise mittels einer Fourier-Transformation des jeweiligen Messsignals. Mit anderen Worten wird die Fourier-Transformierte der Messsignale berechnet, beispielsweise mittels einer FFT. Äquivalent hierzu könnte die spektrale Leistungsdichte des Messsignals, das heißt das Spektrum des Messsignals, ermittelt werden. Dies kann mittels der Autokorrelation des Messsignals erfolgen. Mittels der Fourier-Transformierten des Messsignals wird das Frequenzspektrum des Messsignals berechnet. Der Betrag des Frequenzspektrums wird als Amplitudenspektrum bezeichnet und kann, wie die spektrale Leistungsdichte, ebenfalls zum Ermitteln der Amplituden der Harmonischen herangezogen werden. Entscheidend ist, dass spektrale, das heißt frequenzabhängige Daten aus dem Messsignal ermittelt werden, mittels welchen ein Ermitteln der Harmonischen und ihrer zugehörigen Amplituden möglich ist. Ein besonders bevorzugtes Mittel hierzu ist die Fourier-Transformation und/oder das Berechnen der spektralen Leistungsdichte.

Die aus den Messsignalen ermittelten Amplituden der Harmonischen werden in der Figur 1 mit $\hat{U}_{n,f=mf_0,L,F}$ bezeichnet, wobei $n$ den Knotenpunkt des Stromnetzes (engl. Node), $f_0$ die Grundfrequenz, $mf_0$ die Frequenz der $m$-ten ganzzahligen Harmonischen (engl. Harmonic), $L$ die Phase (engl. Phase/Line Conductor) und $F$ die jeweilige Leitung (engl. Feeder) kennzeichnet. Gemäß dem in Figur 1 dargestellten Ausführungsbeispiel werden die Beträge der Amplituden $\hat{U}_{n,f=mf_0,L,F}$ dem neuronalen Netz 1 zur Zustandsschätzung 21 als Eingänge 41 zugeführt, wobei die $\hat{U}_{n,f=mf_0,L,F}$ aus den erfassten Messsignalen ermittelt werden. Dadurch erfolgt die Zustandsschätzung 21 basierend auf aktuellen Messdaten beziehungsweise ihren zugehörigen aktuellen spektralen Daten.

Werden alternativ oder ergänzend Anstiegszeiten und/oder Abfallzeiten innerhalb der Messsignale als Eingänge 41 verwendet, so können diese mittels des obenstehend beschriebenen Verfahrens, das heißt mittels eines Pade-Laplace-Verfahrens, aus den Messsignalen ermittelt werden. Die ermittelten Anstiegszeiten und/oder Abstiegszeiten werden den zugehörigen Eingängen 41 des neuronalen Netzes 1 zur Zustandsschätzung 21 ebenfalls zugeführt. Hierbei sind - vergleichbar zur Fourier-Transformierten - besonders die Peak-Amplituden (Pole der Pade-Laplace-Transformierten) relevant, da diese den charakteristischen Hochfahrzeiten (Anstiegszeiten) oder Runterfahrzeiten (Abfallzeiten) der jeweiligen Anlagen entsprechen. Beispielsweise weisen Wärmepumpen oder das Laden von E-Autos, solche charakteristischen Zeiten auf, die mittels der Laplace-Transformierten und der anschließenden Bestimmung des (besten) Pade-Approximanten ermittelt werden können. Mit anderen Worten werden diese bevorzugt ebenfalls als Fingerabdrücke zum Lernen des neuronalen Netzes 1 sowie analog zum Berechnen der Zustandsschätzung 21 verwendet.

Alternativ oder ergänzend zur Verwendung der Laplace-Transformierten können aus dem maschinellen Lernen bekannte Verfahren der Zeitreihensegmentierung verwendet werden.

Gemäß dem dargestellten Ausführungsbeispiel werden die erfassten Messsignale ergänzend als Eingänge 41 für das neuronale Netz 1 verwendet. Mit anderen Worten wird beispielsweise der Betrag der Spannung $U_{n,t,L,F}$, der Strom $I_{n,t,L,F}$, die Wirkleistung $P_{n,t,L,F}$ und/oder die Blindleistung $Q_{n,t,L,F}$ als Eingang 41 verwendet. Der Index $t$ deutet die jeweilige Zeitabhängigkeit der genannten Größen an. In der Figur 1 sind die genannten Größen beziehungsweise Eingangsgrößen innerhalb des Blockes 44 zusammengeführt.

Weiterhin können exogene Parameter, wie beispielsweise Temperaturen $T_{n,t}$, geographische Koordinaten und/oder Zeitdaten ($E_{GHI,n,t}$) und/oder Wetterdaten und/oder historische Netzzustände beim Berechnen der Zustandsschätzung als Eingänge verwendet werden. Zusätzlich könnten weiterhin direkt bekannte zeitliche Spannungsprofile bestimmter Anlagen, wie beispielsweise Wärmepumpen, verwendet werden. Somit müssen diese genannten Größen ebenfalls bei Trainieren des neuronalen Netzes 1 vorgesehen sein. Weitere Parameter beziehungsweise Daten können vorgesehen sein.

Die Zustandsschätzung 21 des Stromnetzes kann an den Ausgängen 21 des neuronalen Netzes 1 abgelesen werden. Vorliegend werden die Spannungen oder deren Beträge $|U_{n,t}|$ an den Knotenpunkten (engl. Node Voltages) sowie die Zweigströme $I_{nn',t}$ (engl. Branch Currents) zwischen den Knotenpunkten $n$ und $n'$ (zum jeweiligen Zeitpunkt oder innerhalb des jeweiligen Zeitbereiches) basierend auf den jeweiligen Eingängen/Eingangsdaten 41 mittels des neuronalen Netzes 1 berechnet. Die berechneten Knotenspannungen werden in der Figur 1 durch den Kasten 22 zusammengefasst und gekennzeichnet. Die berechneten Zweigströme werden vorliegend durch den Kasten 24 zusammengefasst und gekennzeichnet.

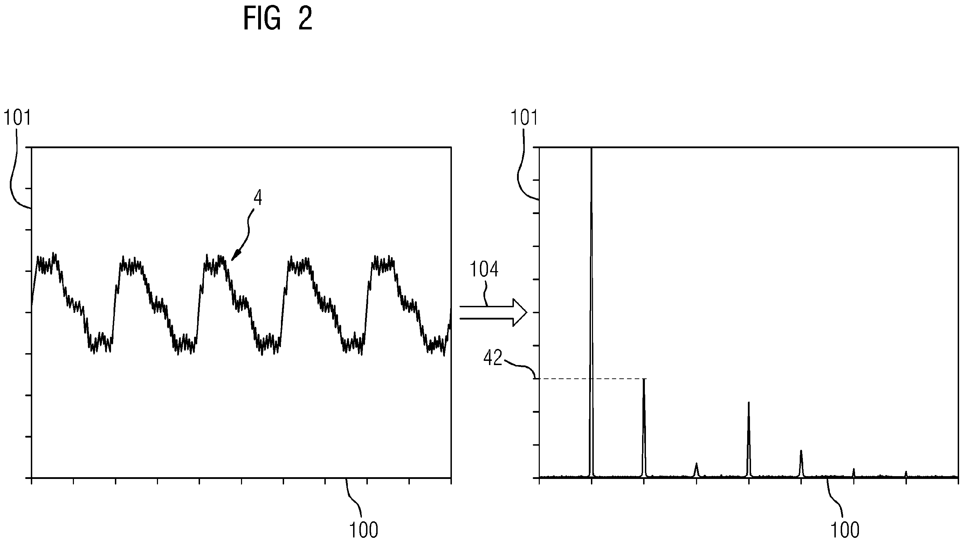

Die Figur 2 zeigt ein Diagramm zur Veranschaulichung der spektralen Daten (Harmonische) eines Messsignals 4.

Das linke Diagramm in Figur 2 zeigt ein exemplarisches zeitliches Messsignal 4 der Spannung an einem Knotenpunkt des Stromnetzes. An der Abszisse 100 des linken Diagramms ist die Zeit in beliebigen Einheiten aufgetragen. An der Ordinate 101 des linken Diagramms ist der Betrag der Spannung in beliebigen Einheiten aufgetragen.

Das Messsignal 4 weist eine Grundfrequenz von 50 Hz auf. Weiterhin weist das Messsignal höher harmonische Anteile auf, die nicht direkt am zeitlichen Verlauf des Messsignals erkennbar sind. Wird beispielsweise eine Fourier-Transformation 104 des Messsignals 4 durchgeführt, so kann insbesondere das Amplitudenspektrum des Messsignals 4 berechnet werden.

Im rechten Diagramm der Figur 2 ist das aus dem Messsignal 4 mittels einer Fourier-Transformation ermittelte Amplitudenspektrum dargestellt. Dieses weist neben Rauschen mehrere Spikes auf, die zu den Harmonischen korrespondieren. Jeder Spike kennzeichnet eine Harmonische, wobei diese verschiedene Amplituden aufweisen. Beispielsweise liegen die Harmonischen für eine Grundfrequenz von 50 Hz im dargestellten rechten Diagramm bei 100 Hz, 150 Hz, 200 Hz, 250 Hz, 300 Hz, 350 Hz und 400 Hz. Die Amplitude der ersten Harmonischen (100 Hz) und der zweiten Harmonischen (100 Hz) sind vorliegend am größten.

Mittels des Amplitudenspektrums können somit die Amplituden der Harmonischen für das jeweilige Messsignal ermittelt werden und für die Zustandsschätzung mittels des neuronalen Netzes oder für dessen Training verwendet werden. Weiterhin kann bevorzugt ein Verhältnis von Amplituden der Harmonischen für die Zustandsschätzung oder dessen Training verwendet werden.

Gemäß der vorliegenden Erfindung werden somit zum Trainieren des neuronalen Netzes und somit zur Zustandsschätzung mittels des entsprechend trainierten neuronalen Netzes spektrale Daten, das heißt höhere Harmonische, verwendet. Weiterhin werden charakteristische Zeiten, die beispielsweise mittels einer Pade-Laplace-Transformierten ermittelt werden können, alternativ oder ergänzend für das Training und somit für die Zustandsschätzung verwendet.

Die erfindungsgemäßen Eingabegrößen (Amplitude von Harmonischen, Anstiegszeiten und/oder Abfallzeiten) bilden einen Fingerabdruck für die am Stromnetz angeschlossenen Anlagen aus, sodass durch die vorliegende Erfindung die Schätzung des neuronalen Netzes im Hinblick auf den Netzzustand deutlich verbessert wird.

Ein weiterer Vorteil der vorliegenden Erfindung ist, dass eine verbesserte Schätzung des Netzzustandes (Zustandsschätzung) ohne weitere oder größere Installationen beziehungsweise Investitionen in das Stromnetz erreicht werden kann. Das erfindungsgemäße Verfahren ist zudem ressourcenschonend, da eine Fourier-Transformation/Laplace-Transformation effizient implementierbar ist, oder bereits direkt durch die Messeinrichtung ausführbar ist.

Zusammenfassend wird eine verbesserte Zustandsschätzung beziehungsweise Netzzustandsschätzung, insbesondere für stark unterdeterminierte Stromnetze, wie beispielsweise Mittelspannung- oder Niederspannungsstromnetze, bereitgestellt. Dadurch kann eine verbesserte intelligente Regelung des Stromnetzes, insbesondere im Hinblick auf digitale Stromnetze und erneuerbare Energien, erreicht werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

Bezugszeichenliste

| | |
|---|---|
| 1 | künstliches neuronales Netz |
| 2 | Zustandsschätzung / Ausgänge |
| 4 | Messsignal |
| 11 | Verborgene Schicht |
| 12 | Ausgabeschicht |
| 14 | Eingabeschicht |
| 21 | Ausgänge/Zustandsschätzung |
| 22 | Spannungen |
| 23 | Ströme |
| 41 | Eingänge |
| 42 | Amplitude/Anstiegszeiten/Abfallzeiten |
| 43 | Weitere Eingänge |
| 44 | Exogene Eingänge |
| 100 | Abzisse |
| 101 | Ordinate |
| 104 | Fourier-Transformation |

**Patentansprüche**

1. Computergestütztes Verfahren zur Zustandsschätzung (2) eines Stromnetzes, insbesondere eines Nieder- und/oder Mittelspannungsnetzes, mittels eines künstlichen neuronalen Netzes (1), wobei das neuronale Netz (1) einen oder mehrere mit dem Stromnetz technisch assoziierte Eingänge (41) aufweist, und die Zustandsschätzung (2) durch erfasste zeitliche Messsignale (4) des Stromnetzes, die als Eingänge (41) für das neuronale Netz (1) herangezogen werden, berechnet wird, **gekennzeichnet dadurch, dass** wenigstens die Amplitude (42) einer Harmonischen eines der Messsignale (4) als Eingang (41) für das neuronale Netz (1) verwendet wird.

2. Verfahren gemäß Anspruch 1, **gekennzeichnet dadurch, dass** die Amplitude (42) der Harmonischen mittels einer Fourier-Transformation (104) des Messsignals (4) ermittelt wird.

3. Verfahren gemäß einem der vorhergehenden Ansprüche, **gekennzeichnet dadurch, dass** zusätzlich ein oder mehrere Verhältnisse von Amplituden (42) von Harmonischen des Messsignals (4) als Eingänge (41) verwendet werden.

4. Verfahren gemäß einem der vorhergehenden Ansprüche, **gekennzeichnet dadurch, dass** zusätzlich eine oder mehrere Anstiegszeiten (42) und/oder ein oder mehrere Abfallzeiten (42) innerhalb des Messsignals (4) als Eingänge (41) verwendet werden.

5. Verfahren gemäß einem Anspruch 4, **gekennzeichnet dadurch, dass** die Anstiegszeiten (42) und/oder Abfallzeiten (42) mittels eines Pade-Laplace-Verfahrens ermittelt werden, wobei die Anstiegszeiten (42) und/oder Abfallzeiten (42) durch die Pole der Pade-Approximation der Laplace-Transformierten des Messsignals (4) ermittelt werden.

6. Verfahren gemäß Anspruch 5, **gekennzeichnet dadurch, dass** für die Pade-Approximation die Ordnung $[n/(n-1)]$ verwendet wird.

7. Verfahren gemäß Anspruch 6, **gekennzeichnet dadurch, dass** $n$ bis zu einem festgelegten maximalen Wert solange erhöht wird, bis keine weiteren Anstiegszeiten (42) und/oder Abfallzeiten (42) ermittelt werden.

8. Verfahren gemäß einem der vorhergehenden Ansprüche, **gekennzeichnet dadurch, dass** zusätzlich Amplituden (42) von Subharmonischen des Messsignals (4) als Eingänge (41) verwendet werden.

9. Verfahren gemäß einem der vorhergehenden Ansprüche, **gekennzeichnet dadurch, dass** die Messsignale (4) ein oder mehrere Spannungssignale, ein oder mehrere Stromsignale, ein oder mehrere Wirkleistungssignale, und/oder ein oder mehrere Blindleistungssignale des Stromnetzes, umfassen, die zusätzlich als Eingänge (41) verwendet werden.

10. Verfahren gemäß einem der vorhergehenden Ansprüche, **gekennzeichnet dadurch, dass** die Messsignale (4) an Knotenpunkten des Stromnetzes, insbesondere an Umspannwerken und/oder Transformatorenstationen, erfasst werden.

11. Verfahren gemäß einem der vorhergehenden Ansprüche, **gekennzeichnet dadurch, dass** als neuronales Netz (1) ein neuronales Netz verwendet wird, welches mittels eines Trainingsdatensatzes trainiert wurde, der mehrere Amplituden (42) von Harmonischen eines und/oder mehrerer Messsignale (4) umfasst, wobei zum Trainieren des neuronalen Netzes (1) die Amplituden (42) der Harmonischen als Eingänge (41) verwendet wurden.

12. Verfahren gemäß einem der vorhergehenden Ansprüche, **gekennzeichnet dadurch, dass** als neuronales Netz (1) ein neuronales Netz verwendet wird, welches mittels eines Trainingsdatensatzes trainiert wurde, der mehrere Anstiegszeiten (42) und/oder Abfallzeiten (42) von einem und/oder mehreren Messsignalen (4) umfasst, wobei zum Trainieren des neuronalen Netzes (1) die Anstiegszeiten (42) und/oder Abfallzeiten (42) als Eingänge verwendet wurden.

13. Verfahren gemäß einem der vorhergehenden Ansprüche, **gekennzeichnet dadurch, dass** die Zustandsschätzung (2) für ein als Niederspannungsnetz und/oder Mittelspannungsnetz ausgebildetes Stromnetz erfolgt.

14. Verfahren zum Trainieren eines künstlichen neuronalen Netzes (1) zur Zustandsschätzung (2) eines Stromnetzes, insbesondere eines Nieder- und/oder Mittelspannungsnetzes, wobei das neuronale Netz (1) einen oder mehrere mit dem Stromnetz technisch assoziierte Eingänge (41) aufweist, und die Zustandsschätzung (2) durch erfasste zeitliche Messignale (4) des Stromnetzes, die als Eingänge (41) des neuronalen Netzes (1) herangezogen werden, berechnet wird, **gekennzeichnet dadurch, dass** das Trainieren mittels eines Trainingsdatensatzes erfolgt, der mehrere Amplituden (42) von Harmonischen, mehrere Anstiegszeiten (2) und/oder mehrere Abfallzeiten (42) eines und/oder mehrerer Messsignale (4) umfasst, wobei zum Trainieren des neuronalen Netzes (1) die Amplituden (42) der Harmonischen, die Anstiegszeiten (42) und/oder die Abfallzeiten (42) als Eingänge (41) verwendet werden.

15. Künstliches neuronales Netz (1) zur Zustandsschätzung (2) eines Stromnetzes, insbesondere eines Nieder- und/oder Mittelspannungsnetzes, wobei das neuronale Netz (1) einen oder mehrere mit dem Stromnetz technisch assoziierte Eingänge (41) aufweist, und die Zustandsschätzung (2) durch erfasste zeitliche Messsignale (4) des Stromnetzes, die als Eingänge (41) des neuronalen Netzes (1) herangezogen werden, mittels des neuronalen Netzes (1) berechnet wird, **dadurch gekennzeichnet, dass** das neuronale Netz (1) derart ausgebildet ist, dass die Amplitude (42) einer Harmonischen eines der Messsignale (4) als Eingang (41) für das neuronale Netz verwendbar (1) ist.

FIG 1

EP 3 993 207 A1

FIG 2

EP 3 993 207 A1

Europäisches
Patentamt

European
Patent Office

Office européen
des brevets

# EUROPÄISCHER RECHERCHENBERICHT

Nummer der Anmeldung

EP 20 20 4648

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 336 995 A1 (SIEMENS AG [DE]) 20. Juni 2018 (2018-06-20) * Zusammenfassung; Abbildungen * * Absätze [0001] - [0005], [0010] - [0020], [0031] - [0038], [0051] - [0053], [0082] - [0091] * ----- | 1-15 | INV. H02J3/00 G06F17/10 G06N3/02 G06N3/063 G06N3/10 G06Q50/06 H02J13/00 |

RECHERCHIERTE
SACHGEBIETE (IPC)

H02J
G06N

Der vorliegende Recherchenbericht wurde für alle Patentansprüche erstellt

| Recherchenort | Abschlußdatum der Recherche | Prüfer |
|---|---|---|
| München | 17. März 2021 | Hartmann, Martin |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
............................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 20 4648

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-03-2021

| Im Recherchenbericht angeführtes Patentdokument | Datum der Veröffentlichung | Mitglied(er) der Patentfamilie | Datum der Veröffentlichung |
|---|---|---|---|
| EP 3336995 A1 | 20-06-2018 | EP 3336995 A1 | 20-06-2018 |
| | | WO 2018114166 A1 | 28-06-2018 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3518369 A1